# EUROPEAN PATENT APPLICATION

(11) **EP 4 525 566 A1**
(43) Date of publication of application: **19.03.2025**
(21) Application number: 23802973.0
(22) Date of filing: 11.05.2023
(51) Int. Cl.: H05K 5/02, H05K 5/06

(54) **CASE AND ELECTRICAL DEVICE**

(30) Priority: 11.05.2022 CN 202221129860 U
(71) Applicant: Sungrow Power Supply Co., Ltd., Hefei, Anhui 230088 (CN)
(72) Inventor: LU, Zheng, Hefei, Anhui 230088 (CN); LU, Yu, Hefei, Anhui 230088 (CN); ZHANG, Ji, Hefei, Anhui 230088 (CN); LI, Yonghong, Hefei, Anhui 230088 (CN)
(74) Representative: Zacco Norway AS
(86) International application number: PCT/CN2023/093370
(87) International publication number: WO 2023/217204

(57) **Abstract**

A case and an electrical device. The case comprises a case body, a case cover and a connecting mechanism, wherein the case body is provided with a cavity and an opening in communication with the cavity; the case cover covers the opening; and the connecting mechanism is connected between the case body and the case cover, at least one connecting mechanism comprises a reinforcing member, the reinforcing member is connected to the case body, and the material and/or thickness and/or contact area of the reinforcing member of the at least one connecting mechanism is different from that of reinforcing members of the other connecting mechanisms. The technical scheme of the utility model can prevent the case cover from flying out to cause a potential safety hazard, when a machine in the case explodes.

## Description

The present application claims the priority to Chinese Patent Application No. 202221129860.1, titled "CASE AND ELECTRICAL DEVICE", filed with the China National Intellectual Property Administration on May 11, 2022, the entire disclosure of which is incorporated herein by reference.

### FIELD

The present application relates to the technical field of electrical equipment, and in particular to a case and electrical equipment.

### BACKGROUND

At present, a case of electrical and electronic equipment such as an inverter generally have capacitors, relays, electrical modules and other devices therein. When devices inside the case of the electrical and electronic equipment are damaged and fail due to an abnormal operation or a short circuit, harmful gases may be released, resulting in violent combustion and explosion. The power of the explosion may increase with the power level of the equipment, and the pressure generated by the explosion may apply a huge impact on a case cover and blast the case cover away, which causes safety hazards to other equipment and people.

### SUMMARY

A main object of the present application is to provide a case and electrical equipment, so as to prevent a case cover from being blasted away and causing safety hazards when devices inside the case explode.

To achieve the above object, a case is provided according to the present application. The case includes a case body, a case cover, and multiple connection mechanisms,
the case body is provided with a cavity and an opening in communication with the cavity;
the case cover covers the opening;
the multiple connection mechanisms are connected between the case body and the case cover, and at least one of the multiple connection mechanisms includes a reinforcement member connected to the case body; and
a material and/or a thickness and/or a contact area of the reinforcement member of at least one of the connection mechanisms is different from that of the reinforcement member of other connection mechanism.

In an embodiment, each of the multiple connection mechanism includes a first connection mechanism and a second connection mechanism, and each of the first connection mechanism and the second connection mechanism includes a connector, a primary fastener and a secondary fastener;
the primary fastener is connected to the case cover and the connector, and the secondary fastener is connected to the case body and the connector; and
the first connection mechanism further includes a first reinforcement member, and the secondary fastener of the first connection mechanism is connected to the case body through the first reinforcement member.

In an embodiment, the second connection mechanism further includes a second reinforcement member, and the secondary fastener of the second connection mechanism is connected to the case body through the second reinforcement member; and
a connection strength between the second reinforcement member and the case body is lower than a connection strength between the first reinforcement member and the case body.

In an embodiment, a thickness of the second reinforcement member is smaller than a thickness of the first reinforcement member.

In an embodiment, a strength of a material of the second reinforcement member is lower than a strength of a material of the first reinforcement member.

In an embodiment, a contact area between the second reinforcement member and the case body is smaller than a contact area between the first reinforcement member and the case body.

In an embodiment, the first connection mechanism is provided with at least two secondary fasteners, and the at least two secondary fasteners of the first connection mechanism are connected to the same first reinforcement member; and/or
the second connection mechanism is provided with at least two secondary fasteners, and the at least two secondary fasteners of the second connection mechanism are connected to the same second reinforcement member.

In an embodiment, the connector includes a primary connection portion and a secondary connection portion, and the secondary connection portion surrounds a periphery of the primary connection portion; and
the primary fastener passes through the case cover and is connected to the primary connection portion, and the secondary fastener passes through the case cover and is connected to the secondary connection portion.

In an embodiment, each of the first connection mechanism and the second connection mechanism includes a pressing member, the pressing member is provided outside the case cover, and the primary fastener of each of the first connection mechanism and the second connection mechanism is connected to the corresponding pressing member.

In an embodiment, the pressing member includes a mounting portion and a limiting portion, and the limiting portion surrounds a periphery of the mounting portion; and
the primary fastener passes through the mounting portion and the case cover, and is connected to the connector, such that the limiting portion presses the case cover.

To achieve the above object, electrical equipment is further provided according to the present application. The electrical equipment includes the case according to any one of the above solutions.

In an embodiment, the electrical equipment includes an energy storage cabinet, a charging pile or an inverter.

According to the technical solutions of the present application, the connection mechanisms connect the case cover and the case body tightly in a normal state, such that the case is secured and sealed. When the devices inside the case explode, the pressure generated by the explosion applies an impact on the case cover. At this time, since the material and/or the thickness and/or the contact area of the reinforcement member of at least one of the connection mechanisms is different from that of the reinforcement members of other connection mechanisms, some of the connection mechanisms fail and are separated from the case body. As a result, a part of the case ruptures, the case cover deforms, and a gap is formed between the case cover and the case body. In this way, the explosion pressure inside the case can be released in time. Others of the connection mechanisms keep in reliable connections and secure the case cover, which prevents the case cover and explosion matters inside the case from being blasted away, thereby eliminating the safety hazards.

### BRIEF DESCRIPTION OF THE DRAWINGS

For more clearly illustrating embodiments of the present application or the technical solutions in the prior art, drawings referred to describe the embodiments or the conventional technology will be briefly described hereinafter. Apparently, the drawings in the following description are only some examples of the present application, and for those skilled in the art, other drawings may be obtained based on the structures shown in these drawings without any creative efforts.
FIG. 1 is a schematic view showing the structure of a case according to a first embodiment of the present application in a normal state;
FIG. 2 is a schematic view showing the structure of the case according to the first embodiment of the present application in an exploded state;
FIG. 3 is a schematic view showing the structure of a first connection mechanism of a case according to a second embodiment of the present application;
FIG. 4 is a schematic view showing the structure of a second connection mechanism of the case according to the second embodiment of the present application;
FIG. 5 is a schematic sectional view showing the structure of the first connection mechanism of the case according to the second embodiment of the present application;
FIG. 6 is a schematic sectional view showing the structure of the second connection mechanism of the case according to the second embodiment of the present application; and
FIG. 7 is a schematic sectional view showing the structure of a second connection mechanism of a case according to a third embodiment of the present application.

Reference numerals:

| | | | |
|---|---|---|---|
| 100 | case, | 10 | case body, |
| 20 | case cover, | 21 | mounting groove, |
| 30 | first connection mechanism, | 31 | first reinforcement member, |
| 40 | second connection mechanism, | 41 | second reinforcement member, |
| 51 | connector, | 511 | primary connection portion, |
| 512 | secondary connection portion, | 52 | primary fastener, |
| 53 | secondary fastener, | 54 | pressing member, |
| 541 | mounting portion, | 542 | limiting portion. |

Realization of purpose, functional characteristics and advantages of the present application will be further described in conjunction with the embodiments and with reference to the accompanying drawings.

### DETAILED DESCRIPTION OF THE EMBODIMENTS

Technical solutions according to the embodiments of the present application will be described clearly and completely as follows in conjunction with the accompany drawings in the embodiments of the present application. It is obvious that the described embodiments are only a part of the embodiments according to the present application, rather than all of the embodiments. All the other embodiments obtained by those skilled in the art based on the embodiments in the present application without any creative work belong to the scope of protection of the present application.

It should be noted that, if there are directional indications (such as "up", "down", "left", "right", "front", "rear"... ) in the embodiments of the present application, the directional indications are only used to explain the relative positional relationship, movement, and so on, between the components in a particular posture (as shown in the drawings). If the particular posture changes, the directional indications also change accordingly.

Moreover, if there are descriptions such as "first", "second" and the like in the embodiments of the present application, the descriptions such as "first", "second" and the like are only for purpose of description, and should not be interpreted as indicating or implying relative importance or implying the number of the indicated technical features. Thus, the features defined by "first", "second" and the like can express or impliedly include at least one such feature. In addition, the technical solutions among the various embodiments can be combined with each other, but it must be based on the realization of those skilled in the art. When the combination of technical solutions is contradictory or cannot be realized, it should be considered that such a combination of technical solutions does not exist, nor is it within the protection scope of the present application.

### First Embodiment

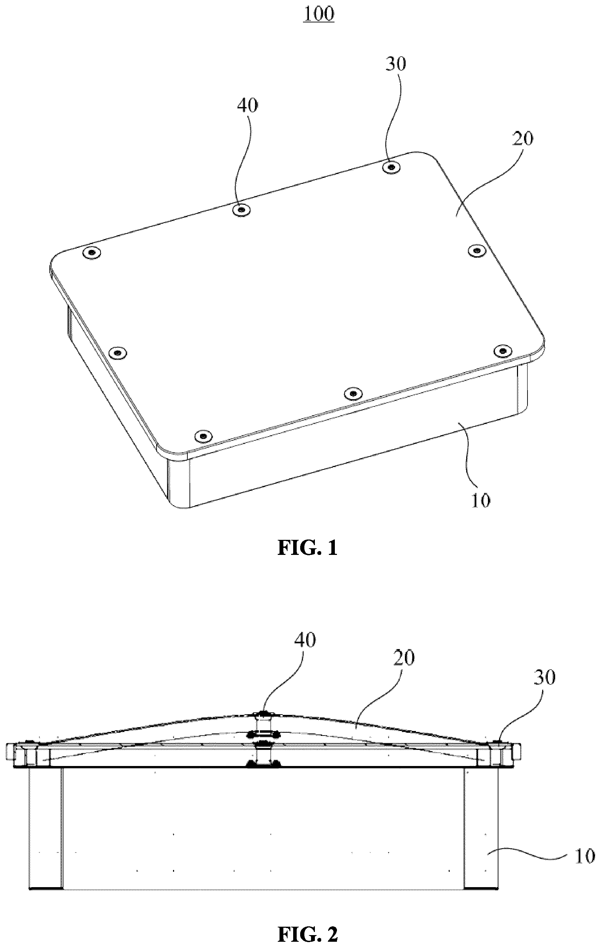

A case 100 is provided according to the present application. As shown in FIG. 1 and FIG. 2, the case 100 includes a case body 10, a case cover 20, and multiple connection mechanisms. The case body 10 is provided with a cavity and an opening in communication with the cavity, and the case cover 20 covers the opening. The multiple connection mechanisms are connected between the case body and the case cover, and at least one of the connection mechanisms includes a reinforcement member connected to the case body. A material and/or a thickness and/or a contact area of the reinforcement member of at least one of the connection mechanisms is different from that of the reinforcement members of other connection mechanisms.

It should be noted that, the case 100 may be but is not limited to a case, a cabinet, a case box or a housing, i.e. an enclosed structure that has a protection function. The specific shape and size of the case is not limited herein.

The case 100 can be applied to an energy storage cabinet, a charging pile, an inverter, or other electrical and electronic equipment that may easily explode due to an abnormal operation or a short circuit. The case body 10 and the case cover 20 of the case 100 are connected through the multiple connection mechanisms. The multiple connection mechanisms are evenly spaced apart along edges of the opening of the case body 10. The connections between the reinforcement members and the case body may be direct or indirect, and may be realized by a screw, a rivet, welding, integral molding or the like.

Referring to FIG. 1, the connection mechanisms connect the case cover 20 and the case body 10 tightly in a normal state, such that the case 100 is secured and sealed. Referring to FIG. 2, when the devices inside the case 100 explode, the pressure generated by the explosion applies an impact on the case cover 20. At this time, since the material and/or the thickness and/or the contact area of the reinforcement member of at least one of the connection mechanisms is different from that of the reinforcement members of other connection mechanisms, some of the connection mechanisms fail and are separated from the case body 10. As a result, a part of the case 100 ruptures, the case cover 20 deforms, and a gap is formed between the case cover 20 and the case body 10. In this way, the explosion pressure inside the case 100 can be released in time. Others of the connection mechanisms keep in reliable connections and secure the case cover 20, which prevents the case cover 20 and exploded matters inside the case 100 from being blasted away, thereby eliminating the safety hazards. The case 100 has a smart structural design and is easy to mount. The structure of the case 100 is reliable and highly safe, while the cost is low.

### Second Embodiment

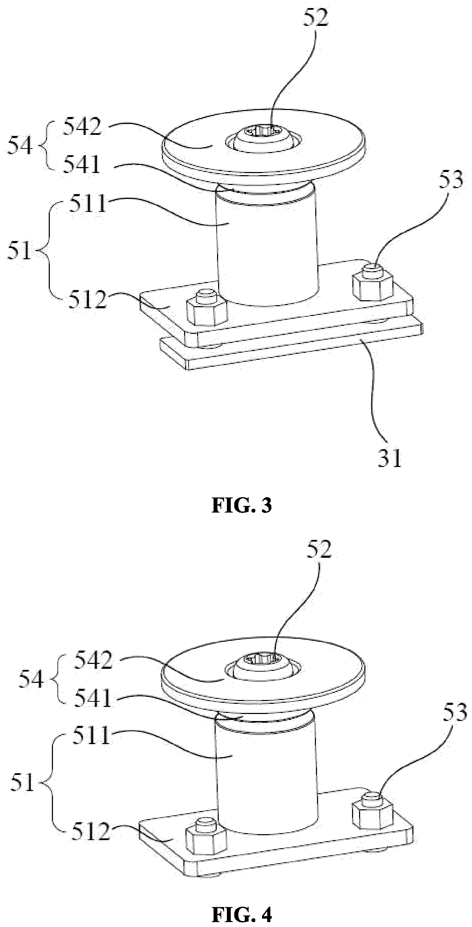

Referring to FIGS. 3 to 6, based on the first embodiment, the connection mechanisms includes at least one first connection mechanisms 30 and at least one second connection mechanisms 40, and each first connection mechanism 30 and the at least one second connection mechanisms 40 includes a connector 51, a primary fastener 52 and a secondary fastener 53. The primary fastener 52 is connected to the case cover 20 and the connector 51, and the secondary fastener 53 is connected to the case body 10 and the connector 51. Each first connection mechanism 30 further includes a first reinforcement member 31, and the secondary fastener 53 of the first connection mechanism 30 is connected to the case body 10 through the first reinforcement member 31. The number of the at least one first connection mechanisms 30 may be more than the number of the at least one second connection mechanisms 40.

In the present embodiment, the structure of each first connection mechanism 30 and the structure of each second connection mechanism 40 are basically the same, i.e. both of them include the connector 51, the primary fastener 52 and the secondary fastener 53. The difference lies in that, each first connection mechanism 30 is further provided with a first reinforcement member 31, and each first connection mechanism 30 is connected to the case body 10 through the first reinforcement member 31, to improve a connection strength between the first connection mechanism 30 and the case body 10. In this way, the connection strength between the first connection mechanism 30 and the case body 10 is different from a connection strength between the second connection mechanism 40 and the case body 10, and the case cover 20 can deform to release the pressure when explosion occurs, which prevents the case cover 20 and explosion matters from being blasted away, and ensures the safety. The first reinforcement member 31 is of a platy structure. Since the secondary fastener 53 of the first connection mechanism 30 is connected to the first reinforcement member 31, the explosion pressure acting on the case cover 20 is transmitted from the case cover 20 to the secondary fastener 53 through the primary fastener 52 and the connector 51 of the first connection mechanism 30, and is dispersed on the case body 10 through the first reinforcement member 31, thereby increasing the connection strength between the first connection mechanism 30 and the case body 10.

It may be appreciated that, to achieve the above object, a connection strength between the first connection mechanism 30 and the case cover 20, and a connection strength between the second connection mechanism 40 and the case cover 20 are both higher than the connection strength between the first connection mechanism 30 and the case body 10, and are certainly higher than the connection strength between the second connection mechanism 40 and the case body 10. Besides, the connection strength between the first connection mechanism 30 and the case cover 20 may be equal to the connection strength between the second connection mechanism 40 and the case cover 20.

In an embodiment, the multiple first connection mechanisms 30 are provided at two sides of an edge of the opening of the case body 10, and each second connection mechanism 40 is provided at a center position of the edge of the opening of the case body 10. In this way, a connection strength at the center position of the case 100 is lower than a connection strength at each of the two sides of the case 100. When devices inside the case 100 explode, the second connection mechanism 40 at the center position of the case 100 ruptures and fails due to the pressure generated by the explosion. A center portion of the case cover 20 bulges and deforms, and a gap is formed between the case cover 20 and the case body 10, thereby releasing the pressure, while the multiple first connection mechanisms 30 at the two sides of the case 100 still keep in reliable connections, preventing the case cover 20 and the explosion matters from being blasted away, thereby safety is ensured. The larger the difference between a strength of each first connection mechanism 30 and a strength of each second connection mechanism 40 is, the easier the case cover 20 deforms, and the better the pressure relief effect and the safety performance are.

In an embodiment, the connector 51 is provided with a first connection hole and a second connection hole. Each of the primary fastener 52 and the secondary fastener 53 may be a bolt. The primary fastener 52 passes through a pressing member 54 and the case cover 20 to be connected to the first connection hole, and the secondary fastener 53 passes through the case body 10 to be connected to the second connection hole, such that the case cover 20 and the case body 10 are connected tightly through the connector 51.

In an embodiment, the connector 51 includes a primary connection portion 511 and a secondary connection portion 512, and the secondary connection portion 512 surrounds a periphery of the primary connection portion 511. The first connection hole is provided on the primary connection portion 511, and the second connection hole is provided on the secondary connection portion 512. With such arrangement, on one hand, the primary fastener 52 and the secondary fastener 53 are connected to the primary connection portion 511 and the secondary connection portion 512 of the connector 51 respectively to facilitate mounting of the primary fastener 52 and the secondary fastener 53 on the connector 51. On the other hand, the structural strength of the connector 51 can be increased, thereby improving the reliability of the overall structure of the case 100.

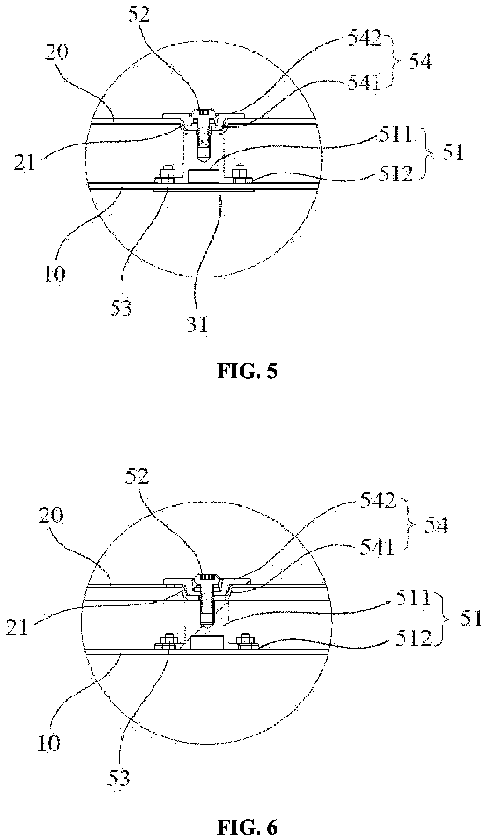

In an embodiment, referring to FIG. 3 and FIG. 5, the first connection mechanism 30 is provided with at least two secondary fasteners 53, and the at least two secondary fasteners 53 of the first connection mechanism 30 are connected to the same first reinforcement member 31.

With the at least two secondary fasteners 53 of the first connection mechanism 30, the stability of the connection between the first connection mechanism 30 and the case body 10 can be improved. Moreover, all of the secondary fasteners 53 of the first connection mechanism 30 are connected to the same first reinforcement member 31, thereby increasing a contact area between the first reinforcement member 31 and the case body 10. When the case cover 20 is impacted by the explosion, the pressure is transmitted by the primary fastener 52, the contact area 51, the secondary fastener 53 and the first reinforcement member 31 of the first connection mechanism 30 to be evenly dispersed on the case body 10, thereby further increasing the structural strength of the first connection mechanism 30.

In an embodiment, referring to FIGS. 3 to 6, each of the first connection mechanism 30 and the second connection mechanism 40 includes a pressing member 54. The pressing member 54 is provided outside the case cover 20, and the primary fastener 52 of each of the first connection mechanism 30 and second connection mechanism 40 is connected to the corresponding pressing member 54.

Specifically, the structure of the pressing member 54 is larger than a mounting hole of the case cover 20. In a normal secured state, the pressing member 54 tightly cooperates with the case cover 20 to stop the case cover 20. With the pressing member 54, the connection strength between the first connection mechanism 30 and the case cover 20 and the connection strength between the second connection mechanism 40 and the case cover 20 are improved, so as to prevent the case cover 20 from being separated from the first connection mechanism 30 and the second connection mechanism 40 when the explosion happens, and prevent the case cover 20 and the explosion matters from being blasted away, and safety is improved.

In an embodiment, referring to FIGS. 3 to 6, the pressing member 54 includes a mounting portion 541 and a limiting portion 542, and the limiting portion 542 surrounds a periphery of the mounting portion 541. The primary fastener 52 passes through the mounting portion 541 and the case cover 20, and is connected to the connector 51, such that the limiting portion 542 presses the case cover 20.

The limiting portion 542 surrounds the periphery of the mounting portion 541, which improves the structural strength of the pressing member 54. In addition, a mounting groove 21 is provided on the case cover 20 in correspondence to the mounting portion 541 of the pressing member 54, so as to facilitate mounting of the mounting portion 541 of the pressing member 54. An outer diameter of the limiting portion 542 of the pressing member 54 is larger than an inner diameter of the mounting groove 21. The limiting portion 542 abuts the surface of the case cover 20, which increases a contact area between the pressing member 54 and the case cover 20. The case cover 20 is stopped by the pressing member 54, and is effectively prevented from being blasted away during explosion.

### Third Embodiment

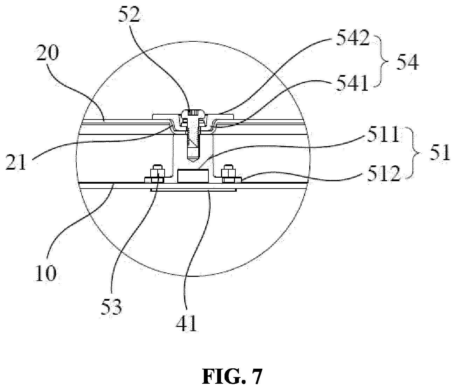

Base on the second embodiment, referring to FIG. 7, the second connection mechanism 40 further includes a second reinforcement member 41, and the secondary fastener 53 of the second connection mechanism 40 is connected to the case body 10 through the second reinforcement member 41. A connection strength between the second reinforcement member 41 and the case body 10 is lower than a connection strength between the first reinforcement member 31 and the case body 10.

In the present embodiment, the structure of the first connection mechanism 30 and the structure of the second connection mechanism 40 are basically the same, i.e. both of them include the connector 51, the primary fastener 52 and the secondary fastener 53. Moreover, the first connection mechanism 30 includes the first reinforcement member 31, and the second connection mechanism 40 includes the second reinforcement member 41. The difference lies in that, a structural strength of the first reinforcement member 31 differs from a structural strength of the second reinforcement member 41. Specifically, the structural strength of the first reinforcement member 31 is higher than the structural strength of the second reinforcement member 41. In this way, the connection strength between the first connection mechanism 30 and the case body 10 is different from the connection strength between the second connection mechanism 40 and the case body 10, whereby the case cover 20 can deform to release the pressure when the explosion occurs, and the case cover 20 is prevented from being blasted away, and safety is ensured.

In an embodiment, referring to FIG. 7, the second connection mechanism 40 is provided with at least two secondary fasteners 53, and the at least two secondary fasteners 53 of the second connection mechanism 40 are connected to the same second reinforcement member 41.

With the at least two secondary fasteners 53 of the second connection mechanism 40, the stability of the connection between the second connection mechanism 40 and the case body 10 can be improved. Moreover, all of the secondary fasteners 53 of the second connection mechanism 40 are connected to the same second reinforcement member 41, thereby increasing a contact area between the second reinforcement member 41 and the case body 10. When the case cover 20 is impacted by explosion, the pressure is transmitted by the primary fastener 52, the contact area 51, the secondary fastener 53 and the second reinforcement member 41 of the first connection mechanism 40 to be evenly dispersed on the case body 10, thereby further increasing the connection strength of the second connection mechanism 40.

### Fourth Embodiment

Based on the third embodiment, a thickness of the second reinforcement member 41 is smaller than a thickness of the first reinforcement member 31.

In the present embodiment, since the thicknesses of the first reinforcement member 31 and the second reinforcement member 41 are different, the connection strength between the first connection mechanism 30 and the case body 10 differs from the connection strength between the second connection mechanism 40 and the case body 10, such that the connection of the second connection mechanism 40 easily fails and the second connection mechanism 40 is separated from the case body 10 when the explosion occurs, and the case cover 20 deforms to release the pressure, while the first connection mechanism 30 keeps in a reliable connection and secures the case cover 20, which prevents the case cover 20 from being blasted away, thereby safety is ensured.

### Fifth Embodiment

Based on the third embodiment, a strength of a material of the second reinforcement member 41 is smaller than a strength of a material of the first reinforcement member 31. Specifically, the second reinforcement member 41 and the first reinforcement member 31 may be made of aluminum alloys, zinc alloys, carbon steels, stainless steels, plastics or the like, or a combination of some of these materials, such that the strength of the material of the second reinforcement member 41 is smaller than the strength of the material of the first reinforcement member 31.

In the present embodiment, since the strengths of the materials of the first reinforcement member 31 and the second reinforcement member 41 are different, the connection strength between the first connection mechanism 30 and the case body 10 differs from the connection strength between the second connection mechanism 40 and the case body 10, such that the connection of the second connection mechanism 40 easily fails and the second connection mechanism 40 is separated from the case body 10 when the explosion occurs, and the case cover 20 deforms to release the pressure, while the first connection mechanism 30 keeps in a reliable connection and stops the case cover 20, which prevents the case cover 20 from being blasted away, thereby safety is ensured.

### Sixth Embodiment

Based on the third embodiment, a contact area between the second reinforcement member 41 and the case body 10 is smaller than a contact area between the first reinforcement member 31 and the case body 10.

In the present embodiment, the contact area between the second reinforcement member 41 and the case body 10 differs from the contact area between the first reinforcement member 31 and the case body 10, such that the connection strength between the first connection mechanism 30 and the case body 10 is different from the connection strength between the second connection mechanism 40 and the case body 10. The contact area between the first reinforcement member 31 and the case body 10 is relatively large, therefore the connector 51 of the first connection mechanism 30 suffers a more even force under the impact of the explosion, and can hardly be damaged or deform, while the contact area between the second reinforcement member 41 and the case body 10 is relatively small, and the connector 51 of the second connection mechanism 40 suffers a large local force, and is easy to deform under the impact of the explosion. In this way, the connection of the second connection mechanism 40 fails and the second connection mechanism 40 is separated from the case body 10 when the explosion occurs, and the case cover 20 deforms to release the pressure, while the first connection mechanism 30 keeps in a reliable connection and stops the case cover 20, which prevents the case cover 20 from being blasted away, thereby safety is ensured.

## Claims

1. A case, comprising a case body, a case cover, and a plurality of connection mechanisms, wherein
the case body is provided with a cavity and an opening in communication with the cavity;
the case cover covers the opening;
the plurality of connection mechanisms are connected between the case body and the case cover, and at least one of the plurality of connection mechanisms comprises a reinforcement member connected to the case body; and
a material and/or a thickness and/or a contact area of the reinforcement member of the at least one of the plurality of connection mechanisms is different from a material and/or a thickness and/or a contact area of the reinforcement member of other connection mechanism.

2. The case according to claim 1, wherein
each of the plurality of connection mechanism comprises a first connection mechanism and a second connection mechanism, and each of the first connection mechanism and the second connection mechanism comprises a connector, a primary fastener and a secondary fastener;
the primary fastener is connected to the case cover and the connector, and the secondary fastener is connected to the case body and the connector; and
the first connection mechanism comprises a first reinforcement member, and the secondary fastener of the first connection mechanism is connected to the case body through the first reinforcement member.

3. The case according to claim 2, wherein
the second connection mechanism comprises a second reinforcement member, and the secondary fastener of the second connection mechanism is connected to the case body through the second reinforcement member; and
a connection strength between the second reinforcement member and the case body is lower than a connection strength between the first reinforcement member and the case body.

4. The case according to claim 3, wherein a thickness of the second reinforcement member is smaller than a thickness of the first reinforcement member.

5. The case according to claim 3, wherein a strength of a material of the second reinforcement member is lower than a strength of a material of the first reinforcement member.

6. The case according to claim 3, wherein a contact area between the second reinforcement member and the case body is smaller than a contact area between the first reinforcement member and the case body.

7. The case according to any one of claims 3 to 6, wherein
the first connection mechanism is provided with at least two secondary fasteners, and the at least two secondary fasteners of the first connection mechanism are connected to a same first reinforcement member; and/or
the second connection mechanism is provided with at least two secondary fasteners, and the at least two secondary fasteners of the second connection mechanism are connected to a same second reinforcement member.

8. The case according to any one of claims 2 to 6, wherein
the connector comprises a primary connection portion and a secondary connection portion, and the secondary connection portion surrounds a periphery of the primary connection portion; and
the primary fastener passes through the case cover and is connected to the primary connection portion, and the secondary fastener passes through the case cover and is connected to the secondary connection portion.

9. The case according to any one of claims 2 to 6, wherein each of the first connection mechanism and the second connection mechanism comprises a pressing member, the pressing member is provided outside the case cover, and the primary fastener of each of the first connection mechanism and the second connection mechanism is connected to a corresponding pressing member.

10. The case according to claim 9, wherein
the pressing member comprises a mounting portion and a limiting portion, and the limiting portion surrounds a periphery of the mounting portion; and
the primary fastener passes through the mounting portion and the case cover, and is connected to the connector, such that the limiting portion presses the case cover.

11. Electrical equipment, comprising the case according to any one of claims 1 to 10.

12. The electrical equipment according to claim 11, comprising an energy storage cabinet, a charging pile or an inverter.
